**Europäisches Patentamt**

**European Patent Office**

**Office européen des brevets**

(19)

(11) **EP 1 349 286 A1**

(12) **EUROPÄISCHE PATENTANMELDUNG**

(43) Veröffentlichungstag:
  **01.10.2003 Patentblatt 2003/40**

(51) Int Cl.$^7$: **H03M 13/29**, H04L 1/00

(21) Anmeldenummer: **02007030.6**

(22) Anmeldetag: **27.03.2002**

(84) Benannte Vertragsstaaten:
  **AT BE CH CY DE DK ES FI FR GB GR IE IT LI LU MC NL PT SE TR**
  Benannte Erstreckungsstaaten:
  **AL LT LV MK RO SI**

(71) Anmelder: **SIEMENS AKTIENGESELLSCHAFT**
  **80333 München (DE)**

(72) Erfinder:
  • **Finn, Lutz, Dr.**
   **81369 München (DE)**
  • **Roessel. Sabine**
   **81739 München (DE)**
  • **Steib, Gerhard**
   **81739 München (DE)**

(54) **Verfahren zur Decodierung einer mit Hilfe eines binären Faltungscodes verschlüsselten Datenfolge**

(57) Verfahren zur Decodierung einer mit Hilfe eines binären Faltungscodes verschlüsselten Datenfolge aus K Informationsbits mittels einem MaxLogMAP-Algorithmus. In einem ersten Berechnungsdurchgang werden Metrikwerte in einer Vorwärts- und in einer Rückwärtsrichtung bei einem Trellis-Diagramm exakt berechnet, von denen jedoch nur eine Auswahl als Stützstellen für einen weiteren Berechnungsdurchgang in einem Speicher abgelegt wird. Mit Hilfe dieser Stützstellen werden in einem weiteren Berechnungsdurchgang die zwischen den Stützstellen des ersten Berechnungsdurchgangs liegenden Metrikwerte exakt berechnet. Es werden Softoutputwerte zur Decodierung gebildet, die nach n Durchgängen alle exakt ermittelt werden.

FIG 3

**Beschreibung**

Die vorliegende Erfindung betrifft ein Verfahren zur Decodierung einer mit Hilfe eines binären Faltungscodes verschlüsselten Datenfolge aus K Informationsbits mittels einem MaxLogMAP-Algorithmus.

Bei Sprachkanälen und bei Datenkanälen eines Funkkommunikationssystems, das beispielsweise nach dem GSM/EDGE-Mobilfunkstandard ausgeprägt ist, werden zur Datencodierung bzw. Datendecodierung binäre Faltungscodes verwendet. Ein bevorzugter Algorithmus für eine sogenannte "Softinput/Softoutput-Decodierung" ist der bekannte "symbol-by-symbol log-likelihood maximum aposteriori probability"-Algorithmus (LogMAP-Algorithmus), der im allgemeinen mit Hilfe einer Maximum-Approximation (MaxLogMAP-Algorithmus) realisiert wird.

Der grundlegende MAP-Algorithmus ist beispielsweise in der Druckschrift "Optimal Decoding of Linear Codes for Minimizing Symbol Error Rate", L.R. Bahl et al., IEEE Transactions on Information Theory, pp. 284 - 287, March 1974 beschrieben, der MaxLogMAP-Algorithmus kann der Druckschrift "Iterative Decoding of Binary Block and Convolutional Codes", J. Hagenauer et al., IEEE Transactions on Information Theory, vol. 42, no. 2, pp. 429 - 445, March 1996 entnommen werden.

Ein mit Hilfe eines sogenannten "gleitenden Fensters" (Decodierfenster) durchgeführter Window-MaxLogMAP-Algorithmus ist in der Druckschrift "An Intuitive Justification and a Simplified Implementation of the MAP Decoder for Convolutional Codes", A. J. Viterbi, IEEE Journal on Selected Areas in Communications, vo. 16, no.2, pp. 260 - 264, Feb. 1998, beschrieben.

Als Grundlage für die Decodierung einer mit Hilfe eines binären Faltungscodes verschlüsselten Datenfolge dient das binäre Trellis-Diagramm. Ein zu einem Informationsbit der Datenfolge gehörendes Segment des Trellis-Diagramms erfasst alle möglichen Kombinationen von m (Gedächtnislänge des Faltungscodes) vorausgegangen Informationsbits als $2^m$ Ausgangszustände. Weiterhin werden alle sich daraus ergebenden "Umrechnungen" (Codierungen) des Informationsbits als $2^{(m+1)}$ Zustandsübergänge und resultierende $2^m$ Zielzustände als Ausgangszustände für das nächste nachfolgende Informationsbit erfasst. Eine Informationsbitfolge entspricht dabei einem bestimmten Pfad innerhalb des Trellis-Diagramms, wobei mit Hilfe des MaxLogMAP-Algorithmus eine Abfolge der wahrscheinlichsten Informationsbits im Trellis-Diagramm ermittelt wird.

Bei der Realisierung des MaxLogMAP-Algorithmus ist grundsätzlich zwischen einer systolischen Realisierung einerseits, und einer prozessor-orientierten Realisierung andererseits zu unterscheiden.
Bei der systolischen Realisierung wird eine möglichst hohe Parallelität von Decodierschritten im gesamten Trellis-Diagramm angestrebt. Diese Realisierung kommt bei extrem hohen Datendurchsatz-Anforderungen von bis zu 50 Gbit/s zur Anwendung.
Die prozessor-orientierte Realisierung ist bei geringem Hardwareaufwand für moderate Datendurchsatz-Anforderungen von einigen Mbit/s geeignet.

Bei beiden Realisierungen wird vorausgesetzt, dass für große, blockweise übertragene Datenfolgen eine Decodierung nur mit Hilfe eines Decodierfenster sinnvoll realisiert werden kann.

Aus Gründen des Datendurchsatzes und des Hardwareaufwands wird zur Decodierung in der Regel der Window-MaxLogMAP-Algorithmus verwendet.

Decodierungs-Ergebnisse (Softoutput-Werte), die vergleichend dazu mit einem MaxLogMAP-Algorithmus ohne Decodierfenster gewonnen werden, sind zwar genauer, jedoch wird hierbei ein großer Aufwand an Hardware und an Speicher benötigt.

Eine Alternative zum MaxLogMAP-Algorithmus wird, bezogen auf eine Blockfehlerrate bei einem gegebenem Signal-Rausch-Abstand, durch den in DE 39 10 739 C3 bzw. in DE 42 24 214 C2 beschriebenen "Softoutput-Viterbi-Algorithmus" (SOVA) gebildet. Der SOVA-Algorithmus weist vergleichend zum MaxLogMAP-Algorithmus jedoch eine geringere Korrelation zwischen Decodierfehlern und gebildeten Softoutput-Werten auf.

Die Aufgabe der vorliegenden Erfindung besteht darin, eine Decodierung einer mit Hilfe eines binären Faltungscodes verschlüsselten Datenfolge mittels MaxLogMAP-Algorithmus derart durchzuführen, dass bei geringem Hardwareaufwand genaue Softoutput-Werte als Decodierungs-Ergebnisse gebildet werden.

Die Aufgabe der Erfindung wird durch die Merkmale des Anspruchs 1 gelöst. Vorteilhafte Weiterbildungen sind in den Unteransprüchen angegeben.

Das erfindungsgemäße Verfahren gehört zu den prozessororientierten Realisierungen des MaxLogMAP-Algorithmus.

Durch die erfindungsgemäße Speicherkaskadierung einerseits und durch die Verwendung von Stützstellen zur Metrikberechnung andererseits, ist der MaxLogMAP-Algorithmus effizient auf genau einem anwenderspezifischen Baustein (ASIC) integrierbar.

Durch den Verzicht auf die Verwendung eines Decodierfensters müssen keine Abstriche bei der Genauigkeit der Decodierungsergebnisse erfolgen.

Die Metrikwerte werden erfindungsgemäß bei einem ersten Berechnungsdurchgang produktiv und bei weiteren Berechnungsdurchgängen auf den abgespeicherten Stützstellen basierend reproduktiv berechnet.

Durch die erfindungsgemäße Speicherkaskadierung wird ein optimaler Datendurchsatz realisiert.

Durch das erfindungsgemäße Verfahren wird Speicherplatz und damit Fläche auf einem ASIC-Baustein eingespart. Die eingesparte Fläche steht somit für weitere Signalverarbeitungsalgorithmen zur Verfügung, wodurch zusätzliche Algorithmen im ASIC-Baustein realisierbar sind.

Im folgenden wird ein Ausführungsbeispiel der Erfindung anhand einer Zeichnung näher erläutert. Dabei zeigt:

FIG 1 eine prinzipielle Darstellung eines MaxLogMAP-Algorithmus zur exakten Berechnung von Softoutput-Werten gemäß dem Stand der Technik,
FIG 2 eine prinzipielle Darstellung eines Window-MaxLogMAP-Algorithmus zur Berechnung von Softoutput-Werten gemäß dem Stand der Technik,
FIG 3 eine prinzipielle Darstellung eines erfindungsgemäßen MaxLogMAP-Algorithmus zur exakten Berechnung von Softoutput-Werten, und
FIG 4 ein Beispiel zur erfindungsgemäßen Metrikwert-Berechnung und Abspeicherung.

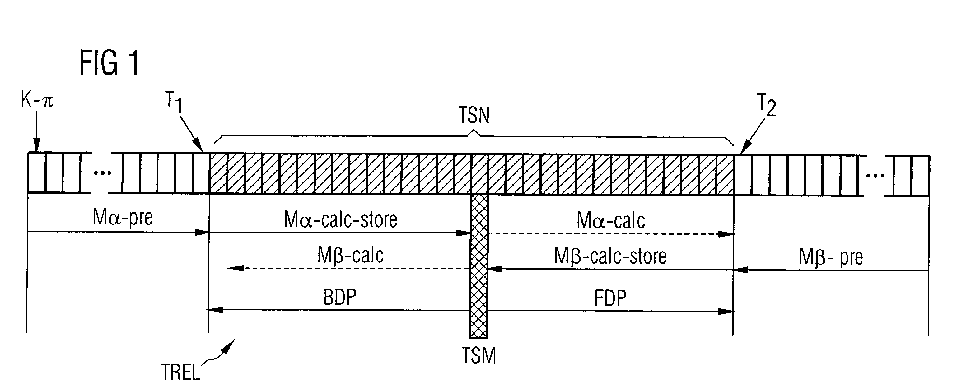

FIG 1 zeigt eine prinzipielle Darstellung eines MaxLogMAP-Algorithmus zur exakten Berechnung von Softoutput-Werten gemäß dem Stand der Technik.

Mit Hilfe des MaxLogMAP-Algorithmus wird eine Decodierung einer mit Hilfe eines binären Faltungscodes verschlüsselten Datenfolge aus K Informationsbits durchgeführt.

Bei einem Trellis-Diagramm TREL werden an einem Trellis-Segment T1 beginnend Alfa-Metrikwerte Mα-calc-store für jedes einzelne Trellis-Segment TSN als logarithmische Übergangs-Wahrscheinlichkeiten berechnet und abgespeichert. Parallel dazu werden gleichzeitig an einem Trellis-Segment T2 beginnend Beta-Metrikwerte Mβ-calc-store für jedes einzelne Trellis-Segment TSN berechnet und abgespeichert.

Die beiden Berechnungen passieren einander an einem Trellis-Segment TSM, wobei ab diesem Zeitpunkt ein Entscheidungsprozess zur Errechnung eines Softoutputwerts durchgeführt wird, d.h. die Decodierung eines Informationsbits der Datenfolge erfolgt. Dabei werden bei einem in Vorwärtsrichtung durchgeführten "Forward-Decision-Process" FDP nach dem Passieren des Trellis-Segments TSM aktuell berechnete Alfa-Metrikwerte Mα-calc mit den früher berechneten und abgespeicherten Beta-Metrikwerten Mβ-calc-store zur Errechnung des Softoutputwerts verwendet.

Dieser Vorgang erfolgt zeitgleich bei einem in Rückwärtsrichtung durchgeführten "Backward-Decision-Process" BDP, bei dem aktuell berechnete Beta-Metrikwerten Mβ-calc mit den früher berechneten und abgespeicherten Alfa-Metrikwerten Mα-calcstore zur Errechnung des Softoutputwerts verwendet werden.

Im Folgenden gilt:

K    Informationsbitanzahl,
s    Zustand einer Faltungscode-Decodierung,
m    Codegedächtnislänge,
T    benötigte Anzahl an Trellis-Segmenten, mit T = K + m, und
π    Länge einer Einschwingphase, mit π > 5*m

Mit einer Wortbreite w eines Metrikspeichers und unter der Annahme, dass die jeweiligen Metrikwerte normiert werden, werden für diese Realisierung des MaxLogMAP-Algorithmus zwei Metrik-Prozessoren und insgesamt **2·K/2·w·2^m** Speicherplätze benötigt. Es wird ein Datendurchsatz erreicht von:

$$\frac{1}{t_{segement}\cdot 10^6}[\text{Mbit/s}].$$

Der oben genannte Parameter $t_{segment}$ ist dabei abhängig von der zur Implementierung des Algorithmus verwendeten Baustein-Technologie (ASIC), von der Speicherarchitektur und von der beim ASIC-Baustein verwendeten Taktrate.

Bei terminierten Codes beginnt die jeweilige Berechnung der Metrikwerte unter der Annahme einer ungleichmäßigen Wahrscheinlichkeitsverteilung bei einem Trellis-Segment mit einem Startzustandswert ("initial-state"), der eine Wahrscheinlichkeit von 100% aufweist, während alle weiteren "states" eine Wahrscheinlichkeit von 0% aufweisen.

Bei den sogenannten "Tailbiting-Codes" ist kein Startzustand von vornherein bekannt, weshalb eine Einschwingphase der Länge π für beide Richtungen eingeführt werden muss. Zugehörige Metrikwerte der Einschwingphase sind mit Mα-pre bzw. mit Mβ-pre bezeichnet.

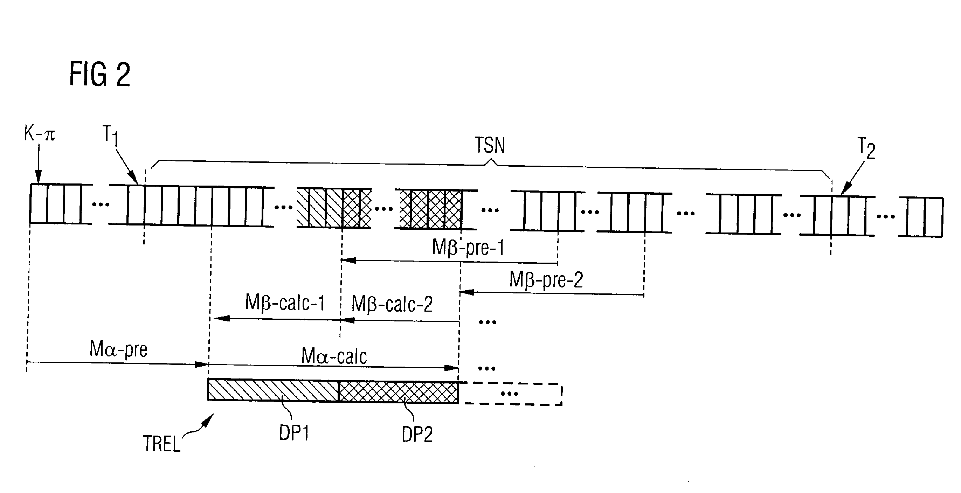

FIG 2 zeigt eine prinzipielle Darstellung eines Window-MaxLogMAP-Algorithmus zur Berechnung von Softoutput-Werten gemäß dem Stand der Technik.

Bei langen Datenfolgen wird der Window-MaxLogMAP-Algorithmus, der mit Hilfe eines gleitenden Decodierfensters realisiert wird, verwendet. Als besonderer Vorteil des Window-MaxLogMAP-Algorithmus ist dessen effiziente Implementierung zu nennen.

Vergleichend mit FIG 1 werden Alfa-Metrikwerte M$\alpha$-calc in Vorwärtsrichtung bei einem Trellis-Segment T1 beginnend exakt berechnet. Demgegenüber werden Beta-Metrikwerte M$\beta$-calc-1 eines ersten Decodierfensters DP1 bzw. Beta-Metrikwerte M$\beta$-calc-2 eines zweiten Decodierfensters DP2 geschätzt.

Erreichen die beiden Decodierfenster DP1 und DP2 den rechten Rand des Trellis-Diagramms TREL, sind alle Terminierungsinformationen vorhanden. Es werden die Beta-Metrikwerte M$\beta$-calc-1 bzw. M$\beta$-calc-2 exakt berechnet und die entsprechenden Softoutput-Werte gebildet.

Metrikwerte M$\alpha$-pre, M$\beta$-pre-1 und M$\beta$-pre-2 werden wiederum einer Einschwingphase zugeordnet.

Der Window-MaxLogMAP-Algorithmus ist in der oben genannten Druckschrift "An Intuitive Justification and a Simplified Implementation of the MAP Decoder for Convolutional Codes"' näher beschrieben.

Bei dieser Realisierung werden bei einem mit FIG 1 vergleichbaren Datendurchsatz insgesamt $\lceil w/\psi \rceil$+1 Metrik-Prozessoren sowie **(1+**$\theta$**)·**$\psi$**·*w*·2$^m$** Speicherplätze benötigt.

Dabei ist:

$\psi$      die Anzahl an Trellis-Segmenten, für die jeweils 2$^m$ Metriken gespeichert werden,

*w*      die Größe des Decodierfensters in Trellis-Segmenten, und

$\theta \in$ {0,1}      ein Parameter, der abhängig von der zur Implementierung des Algorithmus verwendeten Baustein-Technologie (ASIC), von der Speicherarchitektur und von der beim ASIC-Baustein verwendeten Taktrate ist.

Speziell bei Coderaten nahe eins (mit Hilfe von Punktierung erzeugt) hochratiger Kanäle, werden durch Verwendung des Decodierfensters jedoch nicht mehr tolerierbare Performance-Verschlechterungen verursacht.

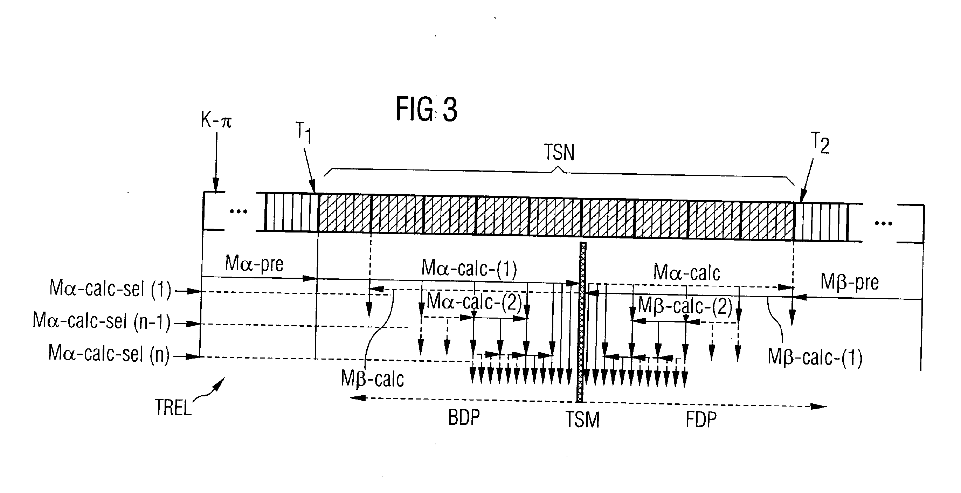

FIG 3 zeigt eine prinzipielle Darstellung eines erfindungsgemäßen MaxLogMAP-Algorithmus zur exakten Berechnung von Softoutput-Werten.

Vergleichend mit FIG 1 werden wieder Alfa-Metrikwerte in einer Vorwärtsrichtung und Beta-Metrikwerte in einer Rückwärtsrichtung jedes Trellis-Segments TSN berechnet. Jedoch werden jetzt erfindungsgemäß nur Metrikwerte einer ausgewählten Anzahl an Trellis-Segmenten, die als Stützstellen dienen, ausgewählt und abgespeichert.

Die Abspeicherung erfolgt in einer bevorzugten Ausführungsform innerhalb eines in Ebenen kaskadiert aufgeteilten Speichers.

Im Folgenden gilt:

m      Codegedächtnislänge,

sm      "memory-length-shift" eines Feed-Forward-Terminated-Codes (bei einem Rekursiv-Terminated-Code und bei einem Tail-Biting-Code ist sm = 0),

K      Informationsbitanzahl,

T      benötigte Anzahl an Trellis-Segmenten, es gilt T = K + m;

$\pi$      Länge der Einschwingphase mit $\pi$ > 5*m.

$\delta$(1)      Speichertiefe einer ersten Speicherebene SP(1) für Stützstellen einer ersten Metrikwert-Berechnung,

$\delta$(n-1)      Speichertiefe einer n-1 ten Speicherebene SP(n-1) für Stützstellen einer n-1 ten Metrikwert-Berechnung, und

$\delta$(n)      Speichertiefe einer n-ten Speicherebene SP(n) für Stützstellen einer n-1 ten Metrikwert-Berechnung.

Beim Trellis-Diagramm TREL werden in einem ersten Durchgang an einem Trellis-Segment T1 beginnend Alfa-Metrikwerte M$\alpha$-calc(1) in einer Vorwärtsrichtung FDP und an einem Trellis-Segment T2 beginnend Beta-Metrikwerte M$\beta$-calc(1) in einer Rückwärtsrichtung BDP für jedes einzelne der Trellis-Segmente TSN als logarithmische Übergangs-Wahrscheinlichkeiten berechnet.

Erfindungsgemäß werden jedoch jetzt aus den errechneten Metrikwerten M$\alpha$-calc(1) bzw. M$\beta$-calc(1) des ersten Durchgangs für eine Auswahl von K/$\delta$(1) Trellis-Segmenten, die als Stützstellen dienen, Metrikwerten M$\alpha$-calcsel(1) bzw. M$\beta$-calcsel(1) des ersten Durchgangs jeweils in einer ersten Speicherebene SP(1) mit einer Speichertiefe von $\delta$(1) abgelegt.

Bei einem zweiten Durchgang werden, basierend auf je zwei benachbarten Stützstellen des ersten Durchgangs, wiederum Metrikwerte M$\alpha$-calc(2) bzw. M$\beta$-calc(2) derjenigen Trellis-Segmente TSN berechnet, die zwischen den jeweiligen Stützstellen des ersten Durchgangs angeordnet sind.

Wie beim ersten Durchgang werden aus den errechneten Metrikwerten M$\alpha$-calc(2) bzw. M$\beta$-calc(2) des zweiten Durchgangs für eine Auswahl von K/$\delta$(1)/$\delta$(2) Trellis-Segmenten, die wiederum als Stützstelen dienen, die entsprechenden Metrikwerte M$\alpha$-calc-sel(2) bzw. M$\beta$-calc-sel(2) des zweiten Durchgangs in einer zweiten Speicherebene SP (2) mit einer Speichertiefe von $\delta$(2) abgelegt.

Diese auf den Stützstellen eines vorhergehenden Durchgangs basierende Metrikwert-Berechnung wird dementsprechend sowohl in Vorwärtsrichtung als auch in Rückwärtsrichtung fortgesetzt. Dabei werden nach dem Passieren des Trellis-Segments TSM entsprechende Softoutput-Werte gebildet, wobei freiwerdende Speicherebenen entsprechend neu eingesetzt werden.

Der Entscheidungsprozess zur Bestimmung der Softoutputwerte erfolgt dabei wie in FIG 1 beschrieben. Die einzelnen Speicherebenen sind zueinander kaskadiert aufgebaut.

Nach n Durchgängen sind alle Softoutputwerte bestimmt, wobei die n-te Speicherebene eine Speichertiefe von $\delta(n)$ mit abgespeicherten Metrikwerten von $K/\delta(1)/\delta(2)/..../ \delta(n)$ Trellis-Segmenten bzw. Stützstellen aufweist.

Vergleichend mit den in den Figuren FIG 1 bzw. FIG 2 angegebenen Datendurchsatz werden durch das erfindungsgemäße Verfahren insgesamt **2·n** Metrik-Prozessoren sowie

$$\left( \sum_{i=1}^{n} \left( 1 + \theta_i \right) \cdot \delta_i \right) \cdot w \cdot 2^m$$

Speicherplätze benötigt.

Es gilt dabei:

$$\prod_{i=1}^{n} \delta_i = K \ , \ \theta_i \in \{0,1\} \ ,$$

in Abhängigkeit davon, wieviele ASIC-Taktzyklen für ein Trellis-Segment benötigt werden und wieviele Ports an den Speichern zur Verfügung stehen.

Anhand von existierenden Realisierungen des MaxLogMAPWindow-Algorithmus können Parameter abgeleitet und für einen Vergleich zwischen den aus FIG 1 bzw. FIG 2 bekannten, herkömmlichen Realisierungen und der erfindungsgemäßen Realisierung verwendet werden.

Die Ergebnisse sind der nachfolgenden Tabelle zu entnehmen:

|  | Logik [Kgates] | Speicher [Kbit] | „Fläche" [Kgates] |
|---|---|---|---|
| MaxLogMAP | 101 | 1080 | 2300 |
| Window-MaxLogMAP | 233 | 138 | 500 |
| speicherkaskadierte Realisierung | 233 | 106 | 450 |

Bei gleichem Datendurchsatz und ohne Abstriche bei der Genauigkeit des MaxLogMAP-Algorithmus, ermöglicht durch die Vermeidung eines Decodierfensters, wird der Hardware-Aufwand bei der erfindungsgemäßen speicherkaskadierten Realisierung um mehr als 80% gegenüber der herkömmlichen in FIG 1 beschriebenen Realisierung verringert.

Dabei wurde für diesen Vergleich vorausgesetzt:

- ein Overhead durch Softinput- und Softoutput Puffer an einer Systemschnittstelle mit $(R^{-1}+1) \cdot w_{soft} \cdot k \cdot a_{memory}$

wobei in der Regel k=K ist, jedoch $k=W+((n_\beta - 1)^* \delta)$ bei der Realisierung mit Decodierfenster sein kann; mit R als Code-Rate, $w_{soft}$ als Wortbreite der Softwerte sowie $a_{memory}$ als Flächeneinheit pro Speicherbit,

- ein Overhead durch Ansteuerung und Schnittstelle: $A_{overhead}$.
- ein Metrik-Prozessor incl. Skalierung der Registerbits:

$$A_{viterbi}(w) \cdot f_{parallel} + 2^{(m+1)} \cdot w \cdot a_{flipflop}$$

wobei $A_{viterbi}$ die Viterbi-Arithmetik für eine gegebene Wortbreite $w$ und $a_{flipflop}$ die Registerflächeneinheit pro Bit darstellen, $f_{parallel}$ ist die Anzahl der in einem ASIC-Taktzyklus ausgeführten Butterfly-Berechnungen und kann folgende Werte annehmen: $\{1,2, ..., 2^{(m-1)}\}$,

- eine Metrik-Wortbreite $w$ = 16,
- eine Softwert-Wortbreite $w_{soft}$ = 8,
- eine Speicherbitfläche $a_{memory}$ = 2,
- eine Registerbitfläche $a_{flipflop}$ = 10 Einheiten,
- ein Viterbi-Arithmetik/Butterfly $A_{viterbi}$ = 12500 Einheiten,
- ein Overhead $A_{overhead}$ = 50000 Einheiten.

Die Einheiten entsprechen einem Gatteräquivalent einer 0,18 μm ASIC-Technologie bei einer Taktfrequenz von rund 150 MHz.

Im Folgenden werden Daten eines GSM/EDGE-Standard relevanten Parametersatz verglichen:

- Code-Rate R = 1/6
- Gedächtnislänge m = 6
- Blockgröße K = 1000
- Decoder-Durchsatz größer als 2 Mbit/s
- Parallelität $f_{parallel}$ = 1

| | Konfiguration (@ 2,6 Mbit/s) | "Fläche" [Kgates] |
|---|---|---|
| exakte Realisierung | 2 Metrik-Prozessoren | 2250 |
| Window - Realisierung (Pfadverschmelzungsli-mit = 160) Fenster auch bei Sof-tinput- und Softout-put-Speicher | 7 Metrik-Prozessoren (1+θ) Metrikspeicher mit δ=32, θ=1 1 Softinput und Softoutput(Speicher mit Fenster | 480 |
| Window - Realisierung (Pfadverschmelzungsli-mit = 160) | 6 Metrik-Prozessoren (1 + θ) Metrikspeicher mit δ=40, θ=1 1 Softinput und Softoutput-Speicher | 500 |
| Window - Realisierung (Pfadverschmelzungsli-mit = 160) | 5 Metrik-Prozessoren (1+θ) Metrikspeicher mit δ=54, θ=0 1 Softinput und Softoutput-Speicher | 425 |
| Speicherkaskadierte Realisierung | 6 Metrik-Prozessoren 2 Stützstellen-Speicher der 1.Ebene mit $\delta_1$=18; (1+$\theta_2$)*2 Stützstellen-Speicher der 2. Ebene mit $\delta_2$=8, $\theta_2$=1; (1+$\theta_3$)*2 Metrik-Speicher mit $\delta_3$=7, $\theta_3$=1; 1 Softinput und Softoutput-Speicher | 450 |
| Speicherkaskadierte Realisierung | 6 Metrik-Prozessoren 2 Stützstellen-Speicher der 1. Ebene mit $\delta_1$=10; (1+$\theta_2$)*2 Stützstellen-Speicher der 2. Ebene mit $\delta_2$=10, $\theta_2$=0; (1 + $\theta_3$) * 2 Metrik-Speicher mit $\delta_3$=10, $\theta_3$=0; 1 Softinput und Softoutput-Speicher | 400 |

Bei UMTS (W-CDMA) und bei UTRAN TDD Faltungscodes sind für die Faltungsdecodierung folgende Parameter zu verwenden:

- Code-Rate R = 1/3
- Gedächtnislänge m = 8

- Maximale Blockgröße K = 300
- Decoder-Durchsatz größer als 2 Mbit/s
- Parallelität $f_{parallel}$ = 8

| | Konfiguration (@ 3.125 Mbit/s) | "Fläche" [Kgates] |
|---|---|---|
| exakte Realisierung | 2 Metrik-Prozessoren | 2891 |
| Window - Realisierung mit gleitenden Fenster auf Softinput / Sof-toutput Speicher | 6 Metrik-Prozessoren $\delta$=40, $\theta$=1 | 1848 |
| Speicherkaskadierte Realisierung | 4 Metrik-Prozessoren $\delta_1$= 20, $\delta_2$ =**15** $\theta_1$ = 0, $\theta_2$ = 1 | 1206 |

Bei UMTS (W-CDMA) und bei UTRAN TDD Turbo Codes kommt ein MaxLogMAP-Decoder mit geringfügigen Erweiterungen als Teil der Turbo-Decodierung in Betracht. So kann auch hier die speicherkaskadierte Realisierung mit der direkten und der Fenster-Realisierung verglichen werden:

- Code-Rate $R = 1/3$
- Gedächtnislänge $m$ = 3
- Maximale Blockgröße $K = 5200$
- Decoder-Durchsatz größer als $2\ Mbit/s$
- Parallelität $f_{parallel} = 1/4$

| | Konfiguration (@3.125 Mbit/s) | "Fläche" [Kgates] |
|---|---|---|
| exakte Realisierung | 2 Metrik-Prozessoren | 1727 |
| Window - Realisierung mit gleitenden Fenster auch für Softinput/Softoutput-Speicher | 6 Metrik-Prozessoren $\delta$=40, $\theta$=1 | 159 |
| Speicherkaskadierte Realisierung | 8 Metrik-Prozessoren $\delta_1$=13; $\delta_2$=**10**, $\delta_3$=8, $\delta_4$=**5** $\theta_1$ = 0, $\theta_i$ = 1 für i = {2,3,4} | 448 |

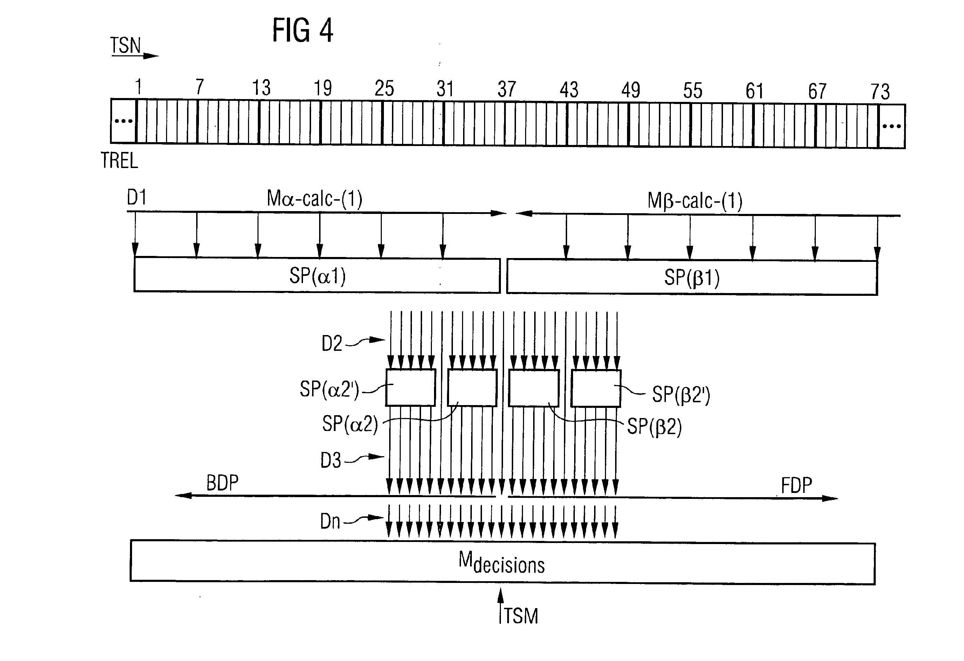

FIG 4 zeigt ein Beispiel zur erfindungsgemäßen Metrikwert-Berechnung und Abspeicherung.

Bei einem ersten Durchgang D1 werden Alfa-Metrikwerte bzw. Beta-Metrikwerte berechnet. Von jedem sechsten Trellis-Segment TSN = 1, 7, 13, ..., 73 als Stützstelle werden jeweils $2^m$ berechnete Alfa-Metrikwerte in einer Speicherebene SP($\alpha$1) und jeweils $2^m$ berechnete Beta-Metrikwerte in einer Speicherebene SP($\beta$1) abgespeichert.

In einem zweiten Durchgang D2 werden diese Metrikwerte aus den Speicherebenen SP($\alpha$1) bzw. SP($\beta$1) ausgelesen und von den zwischen den Stützstellen angeordneten Trellis-Segmenten die zugehörigen Alfa-Metrikwerte bzw. Beta-Metrikwerte exakt berechnet. Wieder wird eine entsprechende Auswahl an Trellis-Segmenten als Stützstellen getroffen und die zugehörigen Metrikwerte abgespeichert. Beispielhaft sind hier zwei Speicherebenen SP($\alpha$2) und SP($\alpha$2') bzw. SP($\beta$2) und SP($\beta$2') angegeben.

In einem dritten Durchgang D3 wird von beiden Seiten her das Trellis-Segment TSM erreicht und es werden für den "Backward-Decision-Process" aktuell berechnete $2^m$ Beta-Metrikwerte mit abgespeicherten $2^m$ Alfa-Metrikwerten, die im Speicher SP($\alpha$2) abgelegt sind, zur Bestimmung von Softoutput-Werten verwendet. Genauso werden für den "Forward-Decision-Process" aktuell berechnete $2^m$ Alfa-Metrikwerte mit abgespeicherten $2^m$ Beta-Metrikwerten, die im Speicher SP($\beta$2) abgelegt sind, zur Bestimmung von Softoutput-Werten verwendet.

Nach insgesamt n=3 Durchgängen Dn wurden alle Entscheidungswerte $M_{decisions}$ gebildet.

**Patentansprüche**

1. Verfahren zur Decodierung einer mit Hilfe eines binären Faltungscodes verschlüsselten Datenfolge aus K Informationsbits,

- bei dem bei einem Trellis-Diagramm mit Trellis-Segmenten in einem ersten Durchgang für eine Vorwärtsrichtung und für eine Rückwärtsrichtung mit Hilfe eines MaxLogMAP-Algorithmus Metrikwerte von allen Trellis-Segmenten exakt berechnet werden,
- bei dem eine Anzahl an Trellis-Segmenten als Stützstellen des ersten Durchgangs ausgewählt und zugehörige Metrikwerte in einer ersten Speicherebene abgespeichert werden,
- bei dem mit 1<i≤n in einem i-ten Durchgang für beide Richtungen Metrikwerte von Trellis-Segmenten berechnet werden, die zwischen den Stützstellen eines i-1 ten Durchgangs angeordnet sind, wobei abgespeicherte Metrikwerte von Stützstellen des i-1 ten Durchgangs zur Berechnung der Metrikwerte des i-ten Durchgangs verwendet werden,
- bei dem eine Anzahl an Trellis-Segmenten als Stützstellen des i-ten Durchgangs ausgewählt und zugehörige Metrikwerte in einer i-ten Speicherebene abgespeichert werden,
- bei dem die auf den Stützstellen basierende Metrikwert-Berechnung und Abspeicherung n-mal erfolgt, bis sich die Metrikwert-Berechnung der Vorwärtsrichtung und der Rückwärtsrichtung bei einem Trellis-Segment treffen und nachfolgend ein Entscheidungsprozess zur Errechnung von Softoutput-Werten zur Decodierung durchgeführt wird.

2. Verfahren nach Anspruch 1, bei dem für jeweils eine Richtung der ersten Speicherebene jeweils eine Speichertiefe von $\delta 1$ zugewiesen wird, wobei in der ersten Speicherebene die jeweiligen Metrikwerte von jedem $K/\delta 1$-ten Trellis-Segment abgespeichert sind.

3. Verfahren nach Anspruch 1 oder 2, bei dem für jeweils eine Richtung der i-ten Speicherebene jeweils eine Speichertiefe von $\delta i$ zugewiesen wird, wobei in der i-ten Speicherebene die jeweiligen Metrikwerte von jedem $K/\delta 1/.../\delta i$ ten Trellis-Segment abgespeichert werden.

4. Verfahren nach einem der vorhergehenden Ansprüche, bei dem bei terminierten Codes für die Berechnung der Softoutputwerte eine verzögerte Entscheidungsphase verwendet wird.

5. Verfahren nach einem der vorhergehenden Ansprüche, bei dem die Decodierung auf genau einem anwenderspezifischen Baustein durchgeführt wird.

FIG 1

EP 1 349 286 A1

FIG 2

K-π   T₁                                    TSN                              T₂

Mβ-pre-1

Mβ-pre-2

Mβ-calc-1   Mβ-calc-2   ...

Mα-pre          Mα-calc          ...

TREL        DP1        DP2        ...

EP 1 349 286 A1

10

FIG 3

# FIG 4

TSN →

TREL

| 1 | 7 | 13 | 19 | 25 | 31 | 37 | 43 | 49 | 55 | 61 | 67 | 73 |

D1  Mα-calc-(1) →  ← Mβ-calc-(1)

SP(α1)    SP(β1)

D2 →

SP(α2') —    — SP(β2')

SP(α2) —    — SP(β2)

D3 →

← BDP    FDP →

Dn →

$M_{decisions}$

↑ TSM

EP 1 349 286 A1

EP 1 349 286 A1

**Europäisches Patentamt**

**EUROPÄISCHER RECHERCHENBERICHT**

Nummer der Anmeldung

EP 02 00 7030

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,A | BAHL L R ET AL: "OPTIMAL DECODING OF LINEAR CODES FOR MINIMIZING SYMBOL ERROR RATE" IEEE TRANSACTIONS ON INFORMATION THEORY, IEEE INC. NEW YORK, US, Bd. IT-20, Nr. 2, 1. März 1974 (1974-03-01), Seiten 284-287, XP000647243 ISSN: 0018-9448 * Seite 284, Spalte 2, Zeile 7 - Seite 287, Spalte 2, letzte Zeile * --- | 1 | H03M13/29 H04L1/00 |
| D,A | VITERBI A J: "AN INTUITIVE JUSITIFICATION AND A SIMPLIFIED IMPLEMENTATION OF THE MAP DECODER FOR CONVOLUTIONAL CODES" IEEE JOURNAL ON SELECTED AREAS IN COMMUNICATIONS, IEEE INC. NEW YORK, US, Bd. 16, Nr. 2, 1. Februar 1998 (1998-02-01), Seiten 260-264, XP000741780 ISSN: 0733-8716 * Seite 260, Spalte 1, Zeile 1 - Seite 264, Spalte 2, letzte Zeile * --- | 1 | |
| | | | RECHERCHIERTE SACHGEBIETE (Int.Cl.7) |
| | | | H03M H04L |
| D,A | HAGENAUER J ET AL: "ITERACTIVE DECODING OF BINARY BLOCK AND CONVOLUTIONAL CODES" IEEE TRANSACTIONS ON INFORMATION THEORY, IEEE INC. NEW YORK, US, Bd. 42, Nr. 2, März 1996 (1996-03), Seiten 429-445, XP000850507 ISSN: 0018-9448 * Seite 429, Spalte 1, Zeile 1 - Seite 445, Spalte 2, letzte Zeile * --- | 1 | |
| D,A | DE 42 24 214 A (DEUTSCHE FORSCH LUFT RAUMFAHRT) 27. Januar 1994 (1994-01-27) * Zusammenfassung * --- -/-- | 1 | |

Der vorliegende Recherchenbericht wurde für alle Patentansprüche erstellt

| Recherchenort | Abschlußdatum der Recherche | Prüfer |
|---|---|---|
| DEN HAAG | 29. Juli 2002 | Van Staveren, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

13

**Europäisches Patentamt**

## EUROPÄISCHER RECHERCHENBERICHT

Nummer der Anmeldung

EP 02 00 7030

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,A | DE 39 10 739 A (DEUTSCHE FORSCH LUFT RAUMFAHRT) 11. Oktober 1990 (1990-10-11) * Zusammenfassung * ----- | 1 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| DEN HAAG | 29. Juli 2002 | Van Staveren, M |

**ANHANG ZUM EUROPÄISCHEN RECHERCHENBERICHT**
**ÜBER DIE EUROPÄISCHE PATENTANMELDUNG NR.**                    EP 02 00 7030

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-07-2002

| Im Recherchenbericht angeführtes Patentdokument | Datum der Veröffentlichung | Mitglied(er) der Patentfamilie | | Datum der Veröffentlichung |
|---|---|---|---|---|
| DE 4224214 A | 27-01-1994 | DE | 4224214 A1 | 27-01-1994 |
| | | FR | 2694647 A1 | 11-02-1994 |
| | | US | 5511081 A | 23-04-1996 |
| DE 3910739 A | 11-10-1990 | DE | 3910739 A1 | 11-10-1990 |
| | | EP | 0391354 A2 | 10-10-1990 |
| | | JP | 2288512 A | 28-11-1990 |
| | | JP | 2533219 B2 | 11-09-1996 |
| | | US | 5181209 A | 19-01-1993 |

EPO FORM P0461

Für nähere Einzelheiten zu diesem Anhang : siehe Amtsblatt des Europäischen Patentamts, Nr. 12/82